# EUROPEAN PATENT SPECIFICATION

(11) **EP 2 764 376 B1**
(45) Date of publication and mention of the grant of the patent: **16.11.2016**
(21) Application number: 11873517.4
(22) Date of filing: 27.09.2011
(51) Int. Cl.: G01R 31/28, G01R 31/26, G01R 31/307

(54) **A METHOD TO DIFFERENTIATE P-CHANNEL OR N-CHANNEL DEVICES BASED ON DIFFERENT ETCHING RATES.**
VERFAHREN ZUR DIFFERENZIERUNG VON P-KANAL- ODER N-KANAL-VORRICHTUNGEN AUF DER BASIS VON VERSCHIEDENEN ÄTZRATEN
PROCÉDÉ PERMETTANT DE DIFFÉRENCIER DES DISPOSITIFS À CANAL P ET À CANAL N SUR LA BASE DE DIFFÉRENTES VITESSES DE GRAVURE

(43) Date of publication of application: 13.08.2014
(73) Proprietor: CHIPWORKS, INCORPORATED, Ottawa, ON K2H 5B7 (CA)
(72) Inventor: KLIBANOV, Lev, Ottawa, Ontario K2G 5Y9 (CA); CAMPBELL, Jeffrey, Stittsville, Ontario K2S 1R3 (CA); SZKARLAT, Robert, Carleton Place, Ontario K7C 3P2 (CA)
(74) Representative: Ertl, Nicholas Justin
(86) International application number: PCT/IB2011/054245
(87) International publication number: WO 2013/045973

(56) References cited:
- CA-A1- 2 521 675
- US-A- 4 623 255
- US-A1- 2002 096 776
- US-A1- 2005 148 157
- RANDY TORRANCE ET AL: "The State-of-the-Art in IC Reverse Engineering", 6 September 2009 (2009-09-06), CRYPTOGRAPHIC HARDWARE AND EMBEDDED SYSTEMS - CHES 2009 (BOOK SERIES: LECTURE NOTES IN COMPUTER SCIENCES), SPRINGER BERLIN HEIDELBERG, BERLIN, HEIDELBERG, PAGE(S) 363 - 381, XP047029957, ISBN: 978-3-642-04137-2 * Chapter 5-6; page 5 - page 14 *
- TORRANCE, R. ET AL.: 'The state-of-the-art in semiconductor reverse engineering' DESIGN AUTOMATION CONFERENCE (DAC), 2011 48TH ACM/EDAC/IEEE 05 June 2011, pages 333 - 338, XP031927672

## Description

### BACKGROUND

### Field of the Invention

The present subject matter relates to semiconductor integrated circuits, and more specifically, to determining if a device on a pre-existing CMOS integrated circuit is a p-channel device or an n-channel device.

### Description of Related Art

Integrated circuits (IC) are often constructed on a silicon wafer with active areas doped to provide an excess of holes for p-type areas and an excess of electrons for n-type areas. The active areas may be arranged to create p-channel metal-oxide field-effect transistors (p-MOSFET, PMOS or p-FET) and/or n-channel metal oxide field-effect transistors (n-MOSFET, NMOS, or n-FET). In some cases, the active areas may be constructed on a non-conductive layer, such as silicon dioxide (SiO2), which may be positioned between the active areas and the silicon wafer. Many integrated circuits may utilize complimentary metal-oxide semiconductor (CMOS) circuits that incorporate both p-FET and n-FET devices into the design.

In most instances, an IC may have one or more layers of polysilicon that may be used for gates of the p-FET and/or n-FET devices as well as being useful as an interconnect layer. In some cases a contact etch stop layer (CESL) may be deposited over the p-FETs and/or n-FETs which may be helpful for "self-aligning" various layers of the IC. Several different stop layers have been used including polysilicon, silicon-rich oxides and oxynitrides, and aluminum oxide. The CESL may be deposited using various techniques including conventional plasma-enhanced chemical vapor deposition (PECVD), high-temperature low-pressure chemical vapor deposition (LPCVD), and sputtering.

A layer of non-conductive material, such as an oxide layer, may then be used to re-level the IC before the metal layers are created and may be referred to as the pre-metal dielectric (PMD). One or more layers of metal interconnect may be deposited on top of the PMD with oxide or other non-conductive material used to insulate the various metal interconnects from each other. Vias may be used to connect between the various layers of the IC.

Integrated circuit (IC) analysis imaging techniques are frequently used during failure analysis and/or reverse engineering of semiconductor devices. Methods for performing this analysis include collection and analysis of emitted radiation, electron microscopy, and conventional optical imaging. The image derived can be examined to determine several characteristics of the IC, which makes the processes especially useful for reverse engineering, failure analysis, and operational analysis. Typically, when the object of the imaging technique is reverse engineering the front side of the integrated circuit is processed and imaged.

Front side imaging allows for viewing of interconnects and active circuit elements of the chip. As is well known in the art, the examination and analysis of integrated circuits requires sophisticated sample preparation techniques and imaging tools. Sophisticated imaging equipment such as a scanning electron microscope (SEM) may be useful in examining modern ICs because components are frequently too small to be visible under an optical microscope. But in many instances, a SEM image may not reveal the desired detail without proper preparation of the surface of the IC.

In the process of examination and analysis, it may be useful to determine a variety of parameters of the IC, depending on the purpose of the analysis. In some cases, an interconnect list may be generated. In some cases, active devices such as field effect transistors (FETs) may be identified. In some cases, it may be helpful to differentiate between p-FET and n-FET devices.

RANDY TORRANCE ET AL: "The State-of-the-Art in IC Reverse Engineering", 6 September 2009, ISBN: 978-3-642-04137-2 discloses reverse engineering techniques pertinent to the semiconductor industry.

### SUMMARY

Various embodiments of a method for examining a complimentary metal-oxide-semiconductor (CMOS) integrated circuit (IC) may include removing at least some material of the CMOS IC above the contact etch stop layer (CESL), and then etching the CMOS IC for a length of time to remove at least some of the CESL. Then the CMOS IC may be inspected to differentiate areas of the CESL. Based on the differentiated areas of CESL, a first area of the CMOS IC may be determined that may include an p-channel metal-oxide-semiconductor (p-FET) device and a second area of the CMOS IC determined that includes a n-channel metal-oxide-semiconductor (n-FET) device.

### BRIEF DESCRIPTION OF THE SEVERAL VIEWS OF THE DRAWINGS

The accompanying drawings, which are incorporated in and constitute part of the specification, illustrate various embodiments of the invention. Together with the general description, the drawings serve to explain the principles of the various embodiments. In the drawings:
FIG. 1 is a flow chart describing an embodiment of a method of examining an integrated circuit (IC);
FIG. 2A is a conceptual drawing of a cross section of a complimentary metal-oxide semiconductor (CMOS) IC;
FIG. 2B is a conceptual drawing of a cross section of the CMOS IC with layers removed down to a pre-metal dielectric (PMD) layer;
FIG. 2C is a conceptual drawing of a cross section of the CMOS IC after some of the contact etch stop layer (CESL) has been etched away;
FIG. 2D is a conceptual drawing of a plan view of the CMOS IC after some of the CESL has been etched away;
FIG. 3A and 3B are photomicrographs of cross sections of a CMOS IC;
FIG. 3C is a photomicrograph of a plan view of the CMOS IC after some of the CESL has been etched away;
FIG. 3D is a conceptual drawing of the plan view of FIG. 3C;
FIG. 4A is a photomicrograph of a cross section of a different type CMOS IC;
FIG. 4B is a photomicrograph of a plan view of the different type of CMOS IC; and
FIG. 5 is a photomicrograph of a plan view of another CMOS IC.

### DETAILED DESCRIPTION

In the following detailed description, numerous specific details are set forth by way of examples in order to provide a thorough understanding of various embodiments. However, it should be apparent to those skilled in the art that the embodiments of the present disclosure may be practiced without such details. In other instances, well known methods, procedures and components have been described at a relatively high-level, without detail, in order to avoid unnecessarily obscuring aspects of the present concepts. A number of descriptive terms and phrases are used in describing the various embodiments of this disclosure. These descriptive terms and phrases are used to convey a generally agreed upon meaning to those skilled in the art unless a different definition is given in this specification. Some descriptive terms and phrases are presented in the following paragraphs for clarity. Reference now is made in detail to the examples illustrated in the accompanying drawings and discussed below.

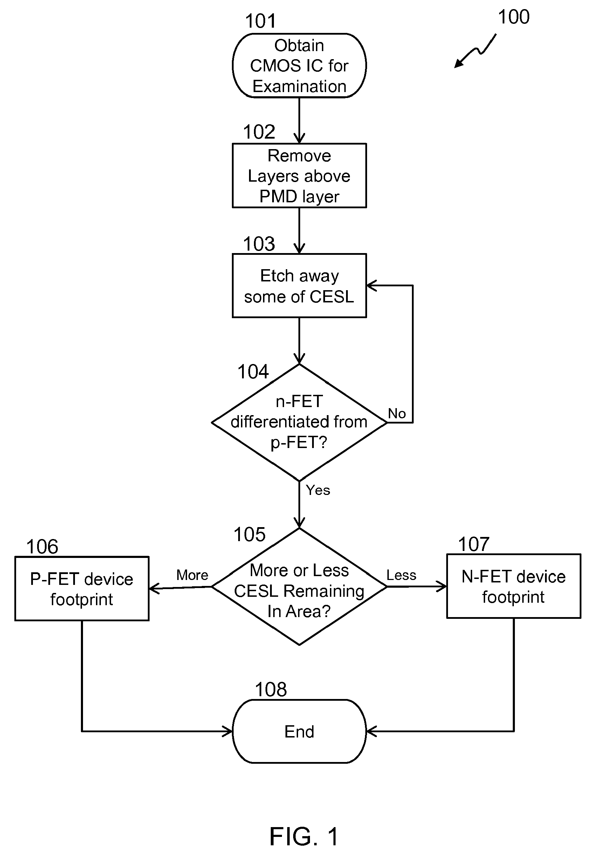

FIG. 1 is a flow chart 100 describing an embodiment of a method of examining an integrated circuit (IC). An IC may be obtained for examination at block 101. The IC die may need to be de-capsulated from any packaging so that the bare die may be examined. At block 102 at least some of the material or layers of material above a contact etch stop layer (CESL) may be removed. In some cases, this may expose a pre-metal dielectric (PMD) layer. Techniques such as wet etching, dry etching, chemical mechanical planarization (CMP), chemical polishing or mechanical polishing are well known in the art and may be useful for removing the material above the CESL.

Some integrated circuits are constructed using aluminum for metal lines in each of the metal layers of the integrated circuit and tungsten for vias interconnecting the metal lines with components formed on a polycrystalline silicon layer. Since aluminum and tungsten can be selectively etched, integrated circuits may be deconstructed using selective etching techniques that permit the vias to be segregated from the metal lines. In order to distinguish vias from metal lines, it may be helpful to acquire images that show contrast between the vias and the metal lines. Tungsten and aluminum are readily distinguished in scanning electron microscope images.

Consequently, one technique for removing the material above the PMD may be to acquire tile images of a deconstructed area of interest of an integrated circuit die. Each metal layer may be covered by an interlayer dielectric (ILD) of a suitable material well known in the art. A metal layer N+1 may be separated from the interlayer dielectric on which it is deposited by a barrier layer, also composed of a suitable material well known in the art. The barrier layers prevent the deposited metal layers N+1, N from migrating into the interlayer dielectric onto which they are deposited. A metal line of metal layer N+1 may be connected to a metal line of metal layer N by a via, which is also formed in a manner well known in the art. The barrier layer that separates via from metal layer N is conductive and provides an electrical connection between the via and the metal line.

In order to acquire tile images of the integrated circuit, passivation layer, and any optional barrier material may be first removed using a wet or dry etching process or a chemical and/or mechanical polishing process to expose metal lines of metal layer N+1. The integrated circuit die may then be placed on a precision stage of the imaging equipment, a scanning electron microscope for example, and tile images acquired of the area of interest in a manner well known in the art. After the tile images of metal layer N+1 have been acquired, the metal layer N+1 may be removed, using, for example, a wet or dry etching process or a chemical and/or mechanical polishing process. The process may be controlled to remove the metal layer N+1 while preserving the integrity of the vias. Thereafter, an etching solution may be selected that will remove the barrier layer as well as the interlayer dielectric while leaving the via intact. If the etching is carefully controlled, the via may remain intact and portions of the barrier layer that are shielded by the via and surround the via remain after etching is complete. Thus metal lines of metal layer N and the via are exposed and tile images of the exposed via and metal layer N are acquired in a manner well known in the art.

This process can be referred to as a "bottom up" process because the vias are imaged in conjunction with the metal lines to which they are connected at their bottom ends. While this technique works well for integrated circuits constructed using aluminum metal lines and tungsten vias due to the different etching characteristics of the two metals, integrated circuits are now being manufactured using copper metal lines and copper vias. As can be understood by those skilled in the art, the etching process is difficult to control when the vias and the metal lines are made of the same metal.

After the integrated circuit die is de-capsulated, a passivation layer covering the first metal layer (metal layer N+1) may be removed. The passivation layer may be removed using an etching process well known in the art. The integrated circuit is then subjected to a wet or dry etching process to etch away metal lines and vias in order to expose an underlying barrier layer. After the metal lines and vias are etched away, the chip may be placed on a precision stage and tile images acquired of any area of interest. It is then determined whether another metal layer of the integrated circuit exits. If so, an interlayer dielectric (ILD) and any barrier material (not shown) that covers the metal lines is also removed. As is understood by those skilled in the art, a barrier layer is usually applied under metal lines but the barrier layer may not be applied over the metal lines. Nonetheless, the process used to remove a passivation layer or an ILD may also remove any barrier material covering metal lines, while leaving the metal lines and any barrier material underlying them. After all metal layers have been exposed, etched away and imaged, the pre-metal dielectric may remain.

An integrated circuit using a copper damascene process may include a passivation layer that covers metal lines of metal layer N+1. A via interconnects the metal line with the metal line in the metal layer N. A barrier layer segregates the metal line from interlayer dielectric material. Barrier layer may be conductive and provides a connection between via and metal line of metal layer N. A barrier layer may separate metal line from the interlayer dielectric to ensure that no metal migrates into the interlayer dielectric, which would change its properties. A wet or dry etching process may then be used to etch away the metal lines and the vias leaving the barrier layer. As will be appreciated by those skilled in the art, this method may produce images in which vias are shown in conjunction with the metal lines to which they are connected at a top end, which is opposite to the methods used in the prior art. The process can therefore by described as a "top down" process.

Once at least some of the material above the contact etch stop layer (CESL), such as the material above the PMD, has been removed, the die may be etched to remove additional material remaining above the CESL and at least some of the CESL at block 103. By using a detailed analysis of device structure of advanced CMOS ICs, it was discovered that a contact etch stop layer (CESL) may have different characteristics for n-FET and p-FET devices. Etching was found to occur at different rates on the two different CESL allowing the device type to be determined. This characteristic has been verified on several advanced CMOS processes and may work on devices built on a buried-oxide layer as may be found in processes using semiconductors built on a non-conductive layer as well as devices built using standard CMOS processes and/or built on bulk silicon substrates.

The methods for etching an IC are well known in the art and may include dry etching or wet etching. In some embodiments, dry etching such as reactive-ion etching (RIE) using various high energy gasses such as Freon or sulfer-hexaflouride may be used. In other embodiments, wet etching using an acid or other liquid may be used. In one embodiment, a mixture of water, hydrofluoric acid, and acetic acid may be used as the wet-etching agent. The etching may be allowed to proceed for a predetermined period of time in some embodiments. In some embodiments, the predetermined period of time may be between 30 and 60 seconds, although in other embodiments the predetermined period of time may be longer or shorter. In some embodiments, the etching time may be controlled using feedback from the etching process.

In some embodiments, an IC that was fabricated using the same fabrication process as the IC to be examined may be cross-sectioned and examined to help determine the etching time and/or the pre-determined period of time. The cross-section may be examined and the thickness of the PMD and/or the CESL may be measured and/or analyzed to determine the material used. The thickness of the PMD and/or CESL along with the material content of the PMD and/or CESL and the etching technique to be used, may be useful in calculating the etching time and/or the predetermined period of time.

At block 104, the IC is inspected to see if the areas of CESL over the p-FETs are differentiated from the areas of CESL over the n-FETs. In some embodiments this may entail using a scanning electron microscope to create a photomicrograph of the top of the IC after the etching process. Other embodiments may use an optical microscope, an atom force microscope, or any other method of inspecting the IC to see if the areas of CESL are differentiated. In many ICs, the CESL over the p-FETs is different than the CESL over the n-FETs and may etch differently, such as etching at different rates. Because the CESL may etch differently, the difference in the CESL may be noticed and used to differentiate between areas of CESL covering p-FET devices and areas of CESL covering n-FET devices. In some cases, all, or nearly all, of the CESL may be removed over one type of FET, while a significant amount of CESL may remain over the other type of FET so that the two types of FETs may be easily distinguished. In other cases, the difference in the amount of CESL remaining may be less significant, but still be noticeable by one of ordinary skill in the art. (In this disclosure and associated claims, the amount of CESL may refer to the thickness of the CESL or the mass of CESL per unit area, as opposed to a total mass of CESL.) In other cases, other characteristics of the CESL covering the two types of FETS may be different, such as opacity, color, texture, physical height, or other such characteristics.

If the areas of CESL covering n-FET and p-FET devices are not differentiated after an initial etch at block 104, another etch step may be performed at block 103. This may then be repeated until the areas of CESL covering n-FET and p-FET devices are differentiated. The subsequent etching steps may be the same predetermined length of time or they may be shorter or longer than the predetermined length of time. In one embodiment, the length of the subsequent etch steps may be shorter than the predetermined length of time to minimize the chance of over-etching and completely removing the CESL from both the n-FET and p-FET devices. In another embodiment, an operator may use the photomicrograph to help decide the length of time for subsequent etching steps.

Once the proper amount of etching has been done so that the areas of CESL covering n-FET and p-FET devices are differentiated, a particular device footprint or set of footprints may be analyzed at block 105 to see if there is a greater or lesser amount of CESL. Other embodiments may use other characteristics to differentiate the areas of CESL. If the particular device footprint or set of footprints has more CESL remaining, the device may be identified as a p-FET device at block 106. If the particular device footprint or set of footprints has less CESL remaining, the device may be identified as a n-FET device at block 107. In other embodiments, the CESL over the p-FET devices may etch more quickly, depending on the characteristics of the CESL and the etching process used. In those embodiments, the p-FET devices may be identified by having less CESL and n-FET devices by having more CESL. The process may end at block 108 after the device footprints of interest have been identified. The methods described herein may be useful on a wide variety of ICs and should not be limited to the examples described below.

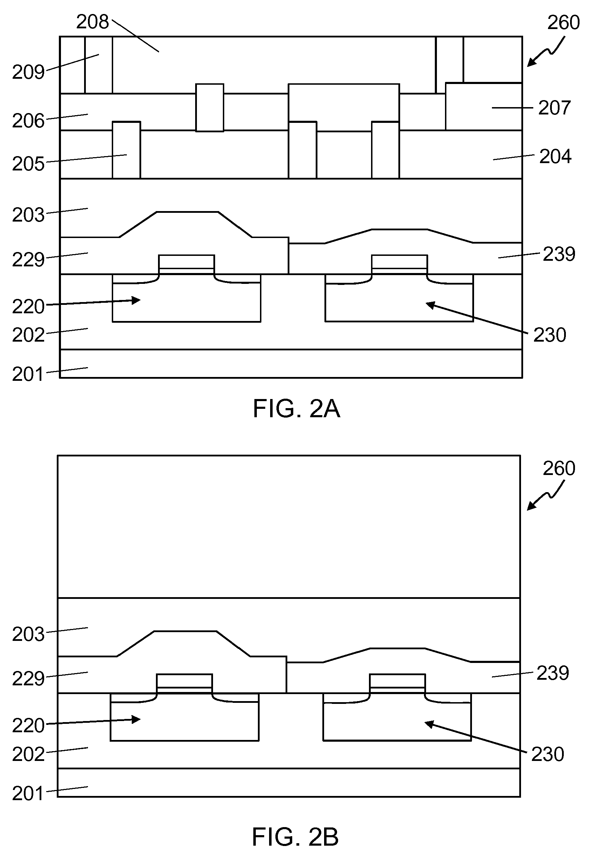

FIG. 2A is a conceptual drawing of a cross section of a complimentary metal-oxide semiconductor (CMOS) IC 260. A substrate 201, which may be a die cut from a silicon wafer, may have a non-conductive layer 202 on top of it. P-FET 220 and n-FET 230 may be built into or on the non-conductive layer 202.

A contact etch stop layer (CESL) may be deposited on top of at least the active areas of the IC. A first type of CESL layer 229 that is designed for p-FET devices may be deposited over areas with p-FETs such as p-FET 220. A second type of CESL layer 239 that is designed for n-FET devices may be deposited over areas with n-FETs such as n-FET 230. The first type of CESL may have different characteristics than the second type of CESL. Some of the differences in the two types of CESL for various IC processes may include different thicknesses, different material, different ion implantation, a double-layer vs a single layer, or other differences. A layer of polysilicon on top of the CESL may be used for interconnect purposes, but is not shown in FIG. 2A. A pre-metal dielectric (PMD) layer 203 may be deposited over the CESL.

One or more layers of metal interconnect may be deposited on top of the PMD. A first layer of metal 205 may be deposited with an insulating layer 204 between the interconnects. A second layer of metal 207 with an insulating layer 206 may be deposited on top of the first metal layer 205 and insulating layer 204. A third layer of metal 209 with insulating layer 208 may be deposited on top of the second layer of metal 207 and insulating layer 206. Vias may be used to connect layers.

FIG. 2B is a conceptual drawing of a cross section of the CMOS IC 260 with layers removed down to a pre-metal dielectric (PMD) layer 203. This corresponds to the state of the IC 260 after the process of block 102 of flowchart 100 has been performed. Note that the metal interconnect layers 205, 207, 209 and insulating layers 204, 206, 208 have been removed. Various techniques such as wet etching, dry etching, CMP or other polishing techniques may be used to remove the material above the PMD layer 203. The first and second type of CESL 229, 239 and the n-FET 230 and p-FET 220 are undisturbed at this step of the process.

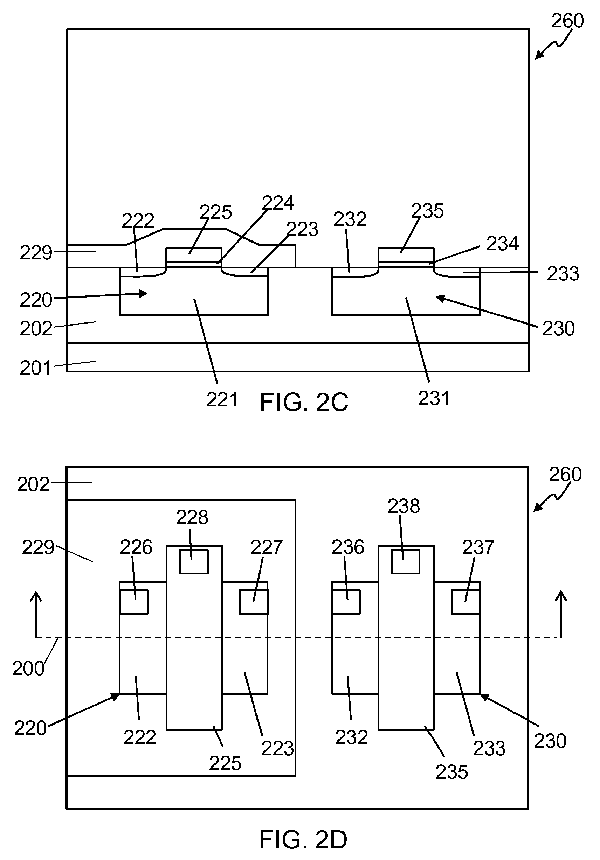

FIG. 2C is a conceptual drawing of a cross section of the CMOS IC 260 after some of the CESL 229, 239 has been etched away. This corresponds to the state of the IC 260 after the processes of block 103/104 of flowchart 100 have been performed. Note that the second type of CESL 239 has been completely removed in FIG. 2C. The first type of CESL 229 has been partially etched away and is thinner in FIG. 2C than in FIG. 2B. In some embodiments not all of the second type of CESL 239 may be removed and a thin layer of the second type of CESL may remain. As long as the p-FET 220 can be differentiated from the n-FET 230, it is not important that all of the second type of CESL 239 is removed.

More detail of the FETs may be seen in FIG. 2C. The p-FET 220 may have a body 221 with a p-type source 222 and drain 223. A thin layer of gate oxide 224 may separate the polysilicon gate 225 from the body 221. The body 221 may be made of silicon or other semiconducting material that may or may not be doped to be n-type material. If a negative voltage is applied to the gate 225 with respect to the source 222 and/or drain 223, a p-channel may be formed in the body 221. The n-FET 230 may have a body 231 with an n-type source 232 and drain 233. A thin layer of gate oxide 234 may separate the polysilicon gate 235 from the channel 231. The body 231 may be made of silicon or other semiconducting material that may or may not be doped to be p-type material. If a positive voltage is applied to the gate 235 with respect to the source 232 and/or drain 233, an n-channel may be formed in the body 231.

FIG. 2D is a conceptual drawing of a plan view of the CMOS IC 260 after some of the CESL 229, 239 has been etched away as in FIG. 2C showing the footprints of p-FET 220 and n-FET 230. The cross sectional views of FIG. 2A, 2B and 2C may be at the place indicated by cut-line 200. The non-conductive layer 202 may be visible along with both the p-FET 220 and the n-FET 230. Since all of the second type of CESL 239 has been removed in this example, it is not visible. The various parts of the n-FET 230 footprint are visible including the gate 235 with via connection 238, the source 232 with via connection 236, and the drain 233 with via connection 237. The first type of CESL 229 may have been partially etched away but is still visible. Various parts of the p-FET 220 footprint may be visible through the first type of CESL 229 including the gate 225 with via connection 228, the source 222 with via connection 226, and the drain 223 with via connection 237. The visible parts of the n-FET 230 and p-FET 220 may be referred to as the footprint. While the footprints shown in FIG. 2D may be simplified, the footprints of actual devices are well known in the art and may be recognized by one of ordinary skill.

The increased amount of the first type of CESL 229 as compared to the second type of CESL 239 may be useful in determining the type of device that may exist in a particular area of the IC 260. A top image, or plan view, of the IC may allow many more devices to be identified from a single image than could be determined from a cross-section or other type of imaging. By using the various embodiments described, the type of devices over a large area of an IC may be identified from a single image.

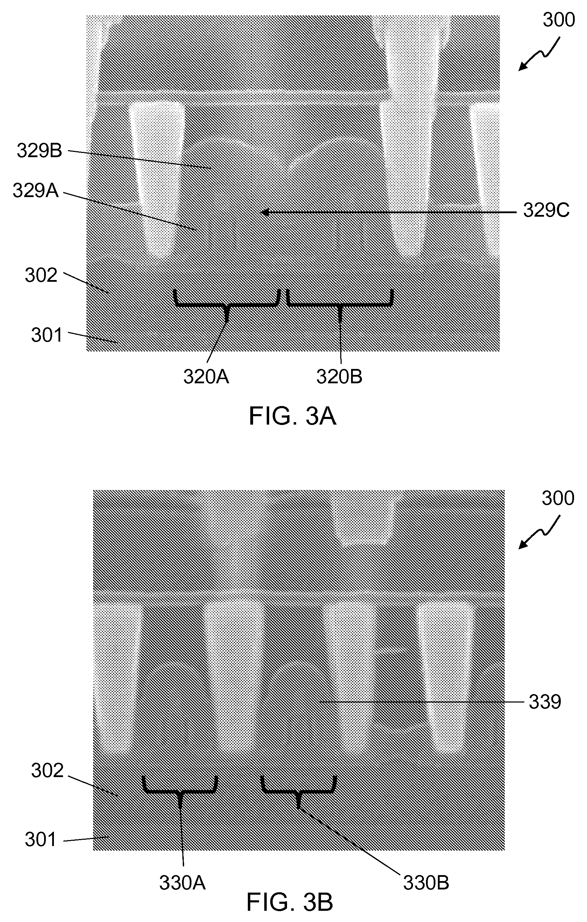

FIG. 3A and 3B are photomicrographs of two different cross sections of a CMOS IC 300. FIG. 3A is a cross section of a part of the IC 300 with two p-FET devices 320A, 320B. The silicon substrate 301 and non-conductive layer 302 may be visible with the p-FETs 320A/B built on top of the non-conductive layer 302. The first type of CESL above the p-FETs 320A/B has two distinct layers 329A and 329B with a faintly visible separating line 329C. FIG. 3B is a cross section of a part of the IC 300 with two n-FET devices 330A and 330B. The silicon substrate 301 and non-conductive layer 302 may be visible with the n-FETs 330A/B built on top of the non-conductive layer 302. The second type of CESL 339 above the n-FET devices 330A/B is only a single layer and is much thinner than the first type of CESL 329 above the p-FET devices 320A/B.

Other characteristics may also be used to differentiate the first type of CESL 329 from the second type of CESL 339. In the example shown, the first type of CESL 329 has more of a concave meniscus with the surrounding structure, while the second type of CESL 339 has a convex meniscus with the surrounding structure. In other ICs, the first type of CESL may exert compressive forced on the area it covers and the second type of CESL may exert tensile forces. The effects of these forces may be visible in various photomicrographs. In other ICs, implanted ions may be visible in one type of CESL but not the other. The implanted ions may be visible as white dots in the photomicrograph. Various techniques known in the art may be used to identify the materials used for the CESL. Any difference in the two different CESLs may be useful to help differentiate them.

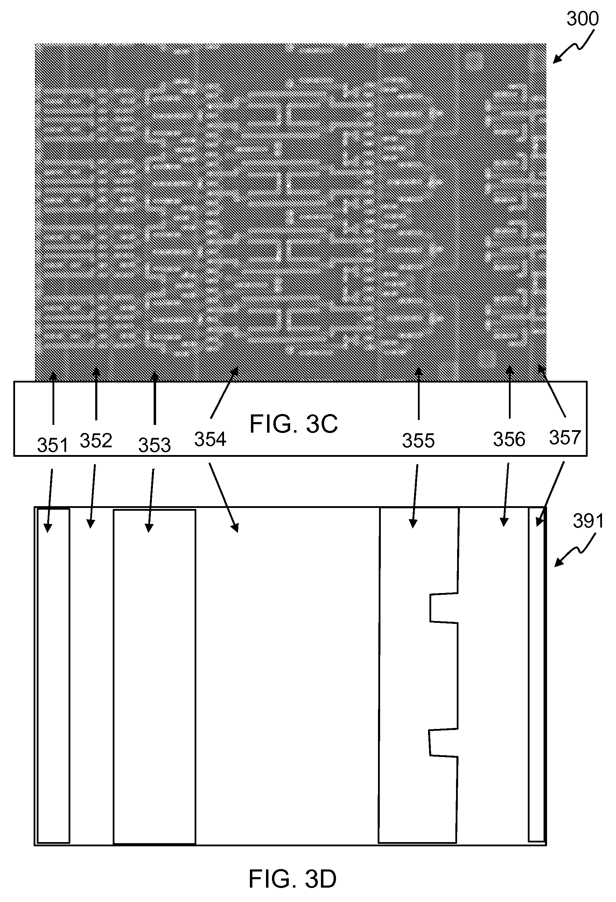

FIG. 3C is a photomicrograph of a plan view of the CMOS IC 300 after some of the CESL has been etched away using a wet etch process. The fine detail may be footprints of various devices and interconnect. Larger areas where CESL remains or has been removed can be identified. FIG. 3D is a conceptual drawing of the plan view of FIG. 3C showing the outline of the CESL areas. Area 351, area 353, area 355 and area 357 show CESL remaining. A MOSFET found in those areas may be identified as a p-FET device. Area 352, area 354 and area 356 have most or all of the CESL etched away. A MOSFET built in any of those areas may be identified as an n-FET device.

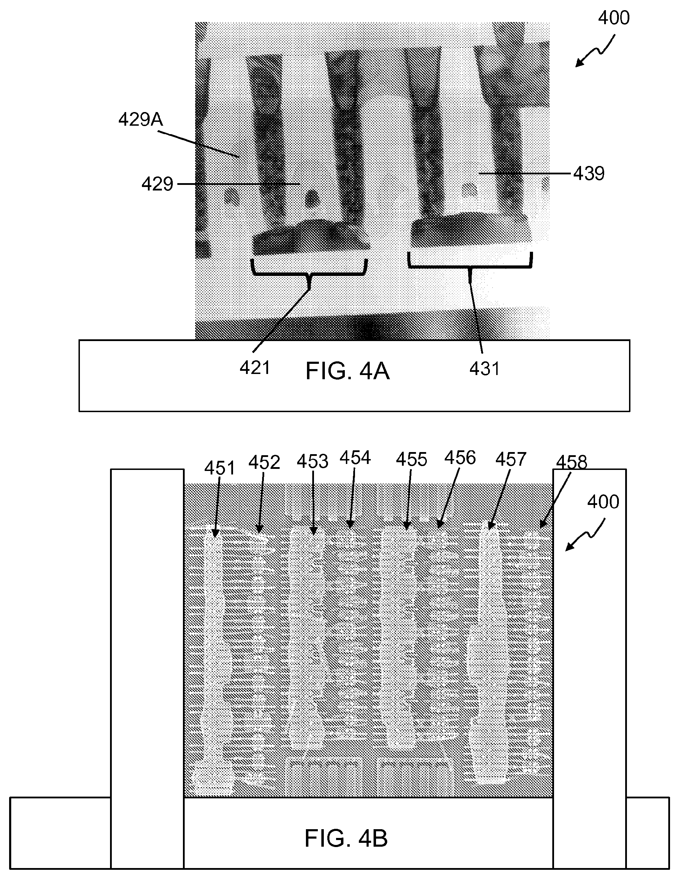

FIG. 4A is a photomicrograph of a cross section of a different type CMOS IC 400 that may have been fabricated using a different process than the IC 300 of FIG. 3. A p-FET device 421 may be covered with a first type of CESL 429. The first type of CESL 429 may be compressive as can be seen from the higher dome on top of the p-FET 421. Another characteristic of the first type of CESL 429 in IC 400 is the CESL tail 429A at the boundaries between the first type of CESL 429 and the second type of CESL 439. An n-FET device 431 may be covered with the second type CESL 439. The second type of CESL 439 may be tensile as can be seen from the broadening of the n-FET 431.

FIG. 4B is a photomicrograph of a plan view of the different type of CMOS IC 400. The photomicrograph was taken after some of the CESL was etched using a wet etch process. The fine detail may be footprints of various devices and interconnect. Certain areas have more CESL remaining than other areas. MOSFETs found in an area with more CESL remaining, such as area 451, area 453, area 455, and area 457, may be identified as p-FET devices. MOSFETs found in an area with less CESL remaining, such as area 452, area 454, area 456 and area 458, may be identified as n-FET devices.

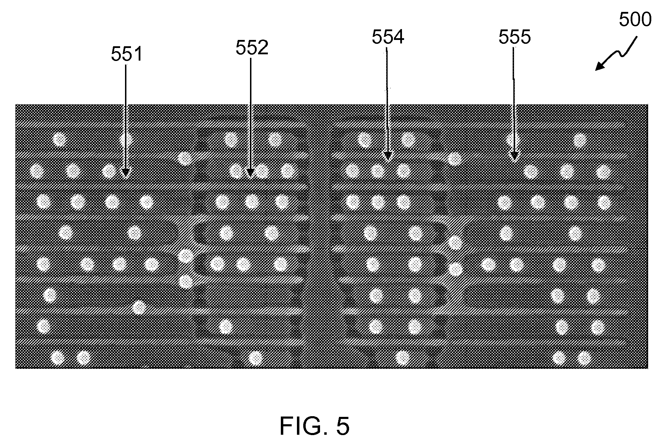

FIG. 5 is a photomicrograph of a plan view of another CMOS IC 500 that has had at least some of the CESL removed using a dry etch process. Reactive ion etching was used to remove at least some of the CESL and some areas can be identified as having more CESL than other areas. MOSFETs found in an area with more CESL remaining, such as area 551, and area 555, may be identified as p-FET devices. MOSFETs found in an area with less CESL remaining, such as area 552 and area 554, may be identified as n-FET devices.

Once the types of MOSFETs have been identified, it may be useful to correlate that information with information extracted from images of the various metal interconnect layers. To do that, the images described herein, it may be helpful to correlate and align the various images to determine a net-list for the IC. The images may be acquired from the same IC die as will be used to determine MOSFET type, or may be another IC die of the same type.

A method may permit alignment of tile images associated with an area of interest of an integrated circuit having N metal layers M, where N is an integer and N is greater than 1. The method may include a first step of preparing a surface of the integrated circuit to permit an area of interest of the metal layer (M_{N}) and at least a part of a top surface of the metal layer (M_{N-1}) to imaged. The method further comprises capturing at least one tile image of the area of interest of the metal layer (M_{N}) and the exposed part of the metal layer (M_{N-1}) of the integrated circuit. Edges of a secondary tile image of the exposed part of metal layer (M_{N-1}) are then extracted, as are edges of a primary tile image of the same area of metal layer (M_{N-1}). A parametric representation of edges visible in the tile images of the respective metal layers is then created. The parametric representations include an indication of the metal layer with which each extracted edge is associated. The parametric representations are used to vertically align tile images, most conveniently when the tile images are displayed on a design analysis workstation. A very high degree of alignment accuracy can be achieved using the method and systems in accordance with the invention. The alignment accuracy permits a more accurate and reliable analysis of the area of interest of the integrated circuit.

The integrated circuit die may first be inspected to determine a component size. If the component size is in the visible light range, optical microscopy can be used for imaging the area of interest. In that case, the area of interest is exposed using any appropriate technique well known in the art. The die is then positioned on the stage to acquire images of the area of interest. A first image may be acquired at a first focus setting to capture a tile image of the exposed metal layer. As is well understood in the art, the insulating layer between layers 1 and 2 is a generally transparent dielectric layer. Consequently, a second image is acquired of the unexposed layer by refocusing the optical microscope without moving the stage. As will be explained below, the second image shows un-occluded parts of the unexposed layer at the same stage position. Since the stage is not moved between acquisition of the first and second images, an exact vertical alignment between the first and second images exists.

After the first and second images are acquired, parametric representations of focused edges on each image are created by extracting at least one of an X and a Y coordinate of each edge. As will be understood by those skilled in the art, it may not be possible to establish both an X and a Y coordinate for each edge extracted from a tile image. For example, wires that extend across a tile image will provide only one of an X and a Y coordinate. Nonetheless, each edge is extracted as well as one or both X and Y coordinates associated with the edge. The parametric representation also includes an indication of the metal layer with which the edge is associated. It is then determined whether the entire area of interest has been imaged. If not, the process repeats by imaging another part of the area of interest. If so, it is determined whether each layer of interest has been imaged. If not, the process exposes a new layer and begins acquiring images. Otherwise the process ends.

If it was determined that the die component size was in the sub-visible light range, a layer of the area of interest is prepared for imaging using a controlled etching process to expose all of the layer as well as at least a part of a layer immediately beneath it. Anisotropic etching may be used with satisfactory results. The die is then positioned on the precision stage for image acquisition, and an image of the exposed first metal layer and partially exposed second metal layer of the die is then captured using, for example, a scanning electron microscope which has a depth of field adequate to simultaneously image the exposed first metal layer as well the at least partially exposed second metal layer. Thereafter, parametric representations of edges on the exposed first metal layer and partially exposed second metal layer are extracted. The extracted edges are assigned to parametric representations on the first metal layer or the second metal layer based on brightness of the respective images. This is achieved because, as will be explained below, although the scanning electron microscope has a depth of field adequate to capture an image of both the exposed first metal layer and partially exposed second metal layer, the exposed first metal layer is brighter in the image than the partially exposed lower layer.

It is then determined whether the entire area of interest has been imaged. If not, the die is repositioned by relocating the stage in a manner well known in the art and more images acquired. If the entire area of interest has been imaged, it is determined whether each layer of interest has been imaged. If not, the process returns removes another set of layers of the IC and the layer of interest is prepared for imaging. As well be understood by those skilled in art, after the first and second layers are imaged, the first layer is removed from the die sample using buffing or polishing in a manner well known in the art. As will be further understood, as an alternative, a separate die may be used to prepare each of the respective layers for imaging.

Tiled images of metal layer N may be created. These may be images focused to show only the integrated circuit components on metal layer N. The images may have been mosaiced to provide a mosaic image in a manner well known in the art. The tile images from an optical microscope are primary images (focused images showing only one metal layer) of metal layer N. As is well understood by those skilled in the art, metal layers of integrated circuits are separated by a silicon glass layer which is transparent to visible light. However, because of the magnifications required only one layer can be brought into focus on an optical microscope during any given image acquisition process. Secondary images (showing a partially obstructed layer in focus) of metal layer M_{N-1} may be acquired.

As is well understood by those skilled in the art, a scanning electron microscope has a greater depth of field than an optical microscope. Consequently, an image of two exposed layers may be captured simultaneously although depending on the choice of imaging parameters of the scanning electron microscope, one layer will have brighter edges than the other layer. In order, to accomplish this, as explained above, the integrated circuit may be etched in a controlled process to exposed metal layer M_{N} and to at least partially expose metal layer M_{N-1}. As is understood by those skilled in the art, the dielectric layer separating the two metal layers is opaque to a scanning electron microscope. It may be desirable to obtain images of each metal layer alone as the only exposed layer in order to facilitate visual analysis to the mosaiced images. Alignment of those mosaiced tile image may be accurately performed using the primary and secondary images as will be explained below in detailed.

An algorithm for adjusting parametric representations of the tile images to achieve virtual alignment between the images may be useful. As is understood by those skilled in the art, the bottom layer of an integrated circuit is normally a polycrystalline silicon layer on which the integrated circuit components are constructed. Layers above are metal interconnect layers containing wires and/or buses for interconnected the first layer components. Consequently, when constructing tile image mosaic for the purpose of analyzing an area of interest the bottom most layer is normally designated layer one and is selected as a die coordinates space home, i.e. a coordinate space used to orient each of the metal layers above. Consequently, the algorithm assumes that the polycrystalline silicon layer is metal layer N and that image mosaic alignment is accomplished in an order opposite that to which the images are normally acquired.

The algorithm begins by comparing parametric representations of a metal layer N+1 secondary tile image with the parametric representations of the metal layer N+1 primary tile images to identify common edges. If no common edges are identified the parametric representations for metal layer N+1 are flagged for interpolation and parametric representations of a next tile image in the image mosaic is selected. If it is determined that common edges exist, the layer N+1 primary tile image representation is aligned with the parametric representation of layer N+1 secondary tile image parametric representation, which is known to be in perfect alignment with the corresponding layer N tile image, as explained above. The alignment between the N+1 primary tile image and the N+1 secondary tile image is accomplished by adjusting X and Y coordinates of common edges in the two parametric representations so that the N+1 primary tile images vertically align with the N+1 secondary tile images. The other edge coordinates in layer N+1 primary tile image parametric representation are then adjusted using the same X, Y offsets. It is then determined whether another tile image exists in the image mosaic. If so, the parametric representations of the primary and secondary tile image are selected.

If no further tile images remain in the image mosaic of layer N+1, it is determined whether parametric representations flagged for interpolation exist. If not, it is determined whether tile images of another layer of the same die integrated circuit exist. If not, the process ends. If so, N is incremented by 1 (and the process repeats to process the next tile image mosaic of the sample die.

If it is determined that parametric representations flagged for interpolation exist, a first of those flagged parametric -representations is selected. Unknown X and/or Y coordinates are interpolated using parametric representations of at least three neighboring tile images having the required coordinate(s). Parametric representations of the flagged primary tile image are then updated using interpolated data, as will be explained below in more detail below. The edge coordinates in layer N+1 primary tile image parametric representation are then adjusted using the X,Y coordinate offset(s) previously computed. It is then determined whether another flagged parametric representation exists.

It may occur that there are no common edges in both of a primary and secondary tile image of an area of interest of the integrated circuit die. As will be understood by those skilled in the art, this situation can arise when, for example, a primary tile image of an area of interest includes only one or more features that are occluded by overlying upper layer structures in the corresponding secondary tile image.

A secondary image of metal layer N and occluded metal layer N-1 includes a visible via. The via may be occluded by the parallel wires of metal layer N in the mage mosaic of metal layer N but may be visible in the mosaic image of metal layer N-1. Alignment data may be extracted from the parametric representations of the primary image of metal layer N-1. As is understood by persons skilled in the art there are many known methods for finding the coordinates of a point when at least one coordinate of some neighboring points are known. By way of example, one method of doing so is to use the well-known technique referred to a Delaunay triangulation.

The X offset of via may be performed using Delaunay triangulation to interpolate a value located between three known points. If three known X coordinates exist, e.g. locations in the image mosaic where known X offsets are located, the position of the via splits the triangle between the known points into three smaller triangles. An area of each smaller triangle is then computed. A ratio between the area of each of these triangles and the area of the original triangle gives a weight to an opposite side of the triangle, as will be understood by those skilled in the art of Delaunay triangulation. As will be further understood by those skilled in the art, the algorithm for using Delaunay triangulation can be optimized. The same process is repeated to compute Y offset data for the via appearing in the metal layer N-1 primary images.

A process may be used for displaying the tile images representing a slice of an area of interest of an integrated circuit die. As will be understood by those skilled in the art, a "slice" of an area of interest is an area designated by an engineer analysts analyzing the area of interest using a design analysis workstation as described below.

If the design analysis workstation receives slice coordinates from the engineer analyst who uses, for example, a mouse connected to the design analysis workstation the system retrieves layer N images required to construct the slice from image storage and assembles the layer N slice. The system then designates layer N as the die coordinate space home to provide a die coordinate space with respect to which all other of the layers in the slice are aligned. As will be understood by those skilled in the art, the actual alignment of mosaic images is performed "on-the-fly" by the design analysis workstation. This is done to permit the engineer analysts to add or change alignment offsets if they find areas where the algorithm has fallen short but where their experience or judgment let them determine a correct alignment between tile images that are incorrectly displayed. The output of the image capture process, as explained above is a set of image mosaics with alignment offsets between them, rather than a set of image mosaics that are perfectly aligned, as understood by those skilled in the art. The engineer analysts can use the primary and secondary images as well as his experience to correct alignment errors that may have been made by the algorithm described above.

The system may retrieve layer N+1 tile images associated with slice coordinates from imaging storage and assemble the layer N+1 slice. The layer N+1 slice is then aligned with layer N slice coordinates space home using the parametric representation data computed as described above. It may then be determined whether another layer of the integrated circuit die exists. If so, N is incremented by 1 and the process to repeats. If not, the slice is displayed in a specified number of windows on a display surface of the design analysis workstation.

It is determined whether the engineer analyst has inputs. If the engineer analyst inputs a quit command, the process ends. If the engineer analyst inputs a scroll, pan or zoom command, etc., parts of the process may repeat. If however, the engineer analysts inputs a new coordinate adjustment for any tile image in any of the slice layer mosaics, the system accepts the new coordinate offsets for the selected tile image in the selected layer Y and adjusts the parametric representations of that tile image. The system then realigns layer Y slice mosaic with layer Y-1 slice mosaic thereafter, each of layers Y+1,... N is realigned with layer Y of the slice using the parametric representation data resulting from the analysts input.

Another process may be used for computing a three-dimensional model of an area of interest of an integrated circuit die. The algorithm begins by receiving slice coordinates from a modeling program. The slice coordinates would normally be coordinates of the entire area of interest, though any selected portion of the area of interest may be modeled, as desired. On receiving the slice coordinates, the algorithm retrieves layer N images from image storage and assembles parametric data associated with the layer N slices. The system then designates layer N as die coordinates space home. Optionally, the algorithm may analyze layer N tile images to build a netlist using pattern matching in a manner known in the art. The system then retrieves layer N+1 tile images associated with the slice coordinates from image storage and assembles layer N+1 slice data. The system then aligns layer N+1 slice data with layer N slice data using the parametric representation data. It is then determined whether there is another layer of images in image storage. If so, N is incremented by 1 and the parts of the process repeat. If not, the vertically aligned slice data is passed to the modeling program and the modeling program executes to construct a three-dimensional model of the slice in a manner known in the art. The algorithm then waits for feedback from the modeling program. The feedback may constitute an end program command, in which case the algorithm terminates. The modeling program may also detect an inconsistency in the data and provide a coordinate adjustment to the algorithm indicating an error in the alignment of images. If the algorithm receives a coordinate adjustment from the modeling program, it adjusts the parametric representation of the selected tile image in the layer Y.The algorithm then realigns the layer Y slice with the layer Y-1 slice and then aligns layer Y+1,... N with realigned layer Y of the slice using the parametric representation data. Thereafter the algorithm passes the vertically re-aligned slice data to the modeling program.

The reverse engineering of integrated circuits typically involves a process by which wafers, cut dies, or portions thereof are inspected using a micro-imaging system to extract design and layout information for design validation or purposes of competitive analysis. A micro-imaging system may be used that may include high magnification optical microscopes, scanning electron microscopes, field emission electron microscopes, or the like. High magnification tile images of the sample die are acquired between each deconstruction step under the control of a computer workstation. The computer workstation controls the micro-imaging system using control signals. The computer workstation receives tile image data from the micro-imaging system and saves the tile image data to memory, typically high capacity storage, such as a hard disk. Generally, the tile image data is transmitted to the high capacity storage and stored in a compressed format minimizing data transfer requirements between the computer workstation and the high capacity storage and, minimizing data storage requirements at the high capacity storage.

The stored tile images are assembled into image-mosaics, each image-mosaic representing a surface of interest of the die at a deconstruction step. During acquisition of the tile images of the die, a sample coordinate space is defined. The sample coordinate space is used to align the tile images and the image-mosaics.

A design analysis workstation (DAW) may include software applications that permit an engineer analyst to reverse-engineer IC's using a pointing device and a monitor, instead of using photographs, markers and paper. The design analysis workstation functions as a reverse-engineering system that enables the engineer analyst to reverse engineer a chip by annotating image-mosaics and performing design and layout display functions. A "chip" in the context of reverse-engineering of an IC, is a fundamental object used to organize data related to the integrated circuit under analysis. A chip includes a number of layers. Each layer corresponds to a physical interconnect layer on a physical IC. A layer is any one of one or more die photos, one or more image-mosaics and one or more annotation overlays.

As explained above, an image-mosaic is an arrangement of a number of acquired tile images. The tile images are of a higher magnification than that of a die photo, which is an image of the entire integrated circuit before deconstruction is begun. The tile images abut together to form a large, seamless high-magnification image of the integrated circuit following a particular deconstruction step. Each image-mosaic can be annotated using one or more annotation overlays, which will be described below.

In analyzing integrated circuits to extract design and layout information, an engineer analyst utilizes the DAW, which has the visual display, a keyboard and a pointing device, such as, but not limited to, a mouse. The visual display has a display area that defines a corresponding display coordinate space. A system pointer displayed in the display area is controlled by the pointing device. The system pointer preferably has a distinctive shape, size and color.

The visual display is typically a Cathode Ray Tube (CRT), a Liquid Crystal Display (LCD), an image projected by an image projector, or the like. Alternatively the display analysis workstation may include a distributed visual display provided by a multi-headed visual display (not shown), a distributed windowing environment spanning visual displays of a plurality of workstations, etc. Distributed windowing environments are commercially available from the XConsortium®, NeXTStep®/OpenStep®, etc.

In accordance with the invention, a plurality of engineer analysts may operate a plurality of design analysis workstations to extract design and layout information concurrently from shared image-mosaics, representative of a deconstructed integrated circuit. The system includes multiuser extensions to provide facilities for synchronizing work of multiple engineer-analysts working on an IC reverse-engineering project, as is described below in more detail with reference to ownership of annotation objects.

The display area displays a navigation window and mosaic-views, each having a view-boundary. The navigation window provides an overall view of the integrated circuit under analysis. The navigation window displays a low magnification digital image of the integrated circuit. When the sample under analysis is a single IC die or a substantial portion thereof, the low magnification image displayed in the navigation window is called a die photo. A slice is selected in the navigation window and defines an area-of-interest on the die photo.

A slice is created in the navigation window by positioning the system-pointer in the navigation window using the pointing device. After the system-pointer is positioned in the navigation window where it is reconfigured and displayed as the master-cursor, a trigger event such as a mouse click is effected by the engineer analyst. The trigger event activates a tool selection menu. The tool selection menu may be a pop-up menu, for example. A menu item appearing in the tool selection menu permits the engineer analyst to activate a slice creation tool. The slice creation tool is used to select an area-of-interest on the die photo by specifying one corner of the area-of-interest by clicking the pointing device and dragging the master-cursor diagonally to create a rectangular slice. The tool selection menu may also be implemented as a pull-down menu. The slice creation tool represents one type of slice creator. In accordance with an alternate embodiment of the invention, the slice creation tool can be activated by issuing a slice creation command. In accordance with a further embodiment, slice creation can be activated using a "hot-key". As will be understood by those skilled in the art, other methods of activating slice creation can also be used.

The man-machine interface is an event-driven interface that reviews events generated in response to the activities of the engineer analyst. As is well understood in the art, interface events may be generated in a plurality of ways, depending on the design of the man-machine interface, as well as the preferences of the engineer analyst. For example, as explained above, the creation of a slice may be enabled by the use of a pop-up menu, a pull-down menu, a hot-key or a command mode of operation. Any one or more of these options may be enabled in the man-machine interface in accordance with the invention.

An event is detected and analyzed to determine whether it is a request for slice creation. As noted above, slice creation can be initiated using a menu selection, a command line or a hot-key, for example. If the event is not a slice creation request, the event is processed and event monitoring resumes. If the event is determined to be a start slice event, the slice creation process monitors for the return of slice coordinates that define an area-of-interest on the die photo. If coordinates are not returned, for example, within a predetermined time interval, the position of the system pointer may be tested to determine whether the system pointer is on the die photo. If so, the process returns to monitoring for the selection of an area-of-interest. If not, a message may be displayed instructing the engineer analyst to select an area-of-interest on the die photo.

When slice coordinates are received, the slice coordinates are stored in memory and a slice creation parameter is examined to determine whether automatic mosaic-view creation is enabled. Automatic mosaic-view creation is a feature provided in accordance with a preferred embodiment of the invention that automatically creates a mosaic-view for each image-mosaic associated with a slice. Alternatively, the mosaic-views to be displayed for a slice may be selected from a list of all image-mosaics associated with the slice. If the slice creation parameter indicates that automatic mosaic-view creation is enabled, an image-mosaic list is retrieved and one mosaic-view defined by the slice coordinates is created for each image-mosaic, and displayed on the display space.

If the slice creation parameter indicates automatic mosaic-view creation is activated, an image-mosaic list is retrieved and one mosaic-view defined by the slice coordinates is created for each image-mosaic, and the mosaic-views are displayed on the display space.

If it is determined that automatic mosaic-view creation is not enabled, a list of the image-mosaics associated with the slice is displayed on the display area to permit the engineer analyst to select the image-mosaics for which mosaic-views are to be created. The slice creation process determines whether at least one image-mosaic has been selected from the list displayed. If not, a message is displayed requesting that an image-mosaic be selected or the process canceled. A mosaic-view is created for each image-mosaic selected and the slice creation process ends.

A process by which lock-step cursor motion is controlled begins and is part of a cursor event processing loop in which a cursor event is detected. The cursor event is analyzed to determine whether the cursor event represents a movement of the cursor. If not, the cursor event is processed. A cursor event such as a "click on the exit button" ends the process.

If the received cursor event is determined to represent a movement of the cursor, the process determines whether the system pointer has, with respect to the display coordinates, crossed a view-boundary of one of the mosaic-views. If it is determined that the system pointer has crossed a view-boundary, the process determines whether the system pointer crossed into a view, or left a view. If it is determined that the system pointer crossed into a view, the system pointer is painted on the display area to represent the master-cursor. The system pointer's display coordinates are converted to sample coordinates. A list of all currently registered views is acquired, and the process iterates through all views in the list sending the cursor event including the sample coordinates of the system master-cursor to each of the views. Each view converts the sample coordinates of the master-cursor into display coordinates of the view and paints a lock-step cursor in the view at the view coordinates. The process may then repeat.

If it is determined that the system pointer has been moved out of a view, representation of the system pointer is restored to its operating system representation. The process acquires a list of registered views and iterates through the list to send the cursor event to each of the registered views. On receiving the cursor event, each view erases the lock-step cursor from the view and the process may repeat.

If it is determined that the cursor event represents a movement of the cursor and the system pointer has not crossed a view-boundary, the process determines whether the system pointer is in a view. If not, then the process may repeat.

If the cursor motion event is received when the system pointer is in a view, the master-cursor's display coordinates are converted into sample coordinates. A list of registered views is retrieved, and the cursor event and the master-cursor's new position with respect to the sample coordinate space are sent in an iterative process to each registered view. Each view erases its lock-step cursor at the position it occupied when the new coordinates were received, and converts the sample coordinates of the master-cursor into display coordinates of the view. The view then repaints the lock-step cursor at the new display coordinates, if the display coordinates are within the view.

Lock-step cursor motion may also be enabled using a global data structure having a scope that extends to all views. The global data structure stores at least the master-cursor's position with respect to the sample coordinate space defined by the physical sample IC under investigation. The man-machine interface processes system pointer events received from the pointing device. When each system pointer event is received, typically via a system interrupt, the man-machine interface displays the system pointer at a current position and updates the master-cursor's position. If the system pointer is within the view-boundary of a view, it is painted on the display surface in the shape and configuration of the master-cursor, and the position of the master-cursor in the sample coordinate space is computed and stored in the global data structure. As part of interrupt processing, each one of the other views determine whether the master-cursor's position with respect to the sample coordinate space is displayable within the view-boundary of the view. If so, the view performs a comparison between the sample coordinate space position of the displayed lock-step cursor and the position stored in the global data structure, erasing and repainting the lock-step cursor in the view as required.

If a plurality of workstations, each having a system pointer, are used in extracting design and layout information concurrently from a plurality of image-mosaics representative of a sample IC, master-cursor contention issues may be resolved using selection criteria to determine which system pointer is the master-cursor. The selection criteria may include: limitation to a particular system pointer of a particular workstation; selecting the last system pointer that generated a cursor event; etc.

Mosaic-views display portions of an image-mosaic obtained after a particular deconstruction step in the process of deconstructing the IC. The slice defines an area-of-interest displayed in each mosaic-view.

Lock-step cursors are displayed within each mosaic-view, when appropriate. A corresponding lock-step cursor may also be shown in the navigation window. Preferably the lock-step cursors are similar in shape, size and color, except for a master-cursor. The master-cursor indicates a current location of the system pointer, controlled by the pointing device, when the system pointer is positioned within a mosaic-view. The master-cursor may have the same appearance as the system pointer, or may have a distinctive shape, size and/or color. Lock-step cursors move in unison under the control of the master-cursor because they share positional coordinates in the sample coordinate space with the master-cursor. The lock-step motion is shown in the diagrams as a trailing effect.

In accordance with a preferred embodiment of the invention, mosaic-views zoom and/or pan in unison, subject to the slice being zoomed or panned. For this purpose the navigation window is shown to have panning sliders.

A slice may have associated mosaic-views. Mosaic-views zoom or pan as any one of the mosaic-views is zoomed or panned. To accommodate this, each of the mosaic-views is provided with panning sliders. The navigation window may have another slice defined. Slice is associated with mosaic-views. Mosaic-views may have dissimilar sizes and each may be resized and zoomed independently.

With the master-cursor inside a mosaic-view, an interactive event such as a mouse click, a key sequence activation, or the like, is performed. In response, an annotation overlay selection menu is displayed. The annotation overlay selection menu provides a list of annotation overlays associated with the chip under analysis and one of the annotation overlays can be selected. As shown, any annotation overlay can be displayed over any image-mosaic to extract design and layout information therefrom by drawing annotation objects on the annotation overlay.

An annotation object is an entity drawn by an engineer analyst on an annotation overlay based on features inferred from at least one image-mosaic displayed in at least one mosaic-view. The image-mosaics are the source images. An image-mosaic forms the background of each mosaic-view. Examples of annotation objects include rectangles, lines, polygons, ovals, text labels, contacts and wires. Annotations can be loaded and saved independently of the image-mosaics.

The mosaic-view is displayed over an image-mosaic derived from a deconstruction step of the integrated circuit that exposed a metal layer. Metal traces are observable at a current pan and zoom factor. An annotation object is created based on the observed features of trace. Once created, the annotation object overlays the trace.

As mentioned above facilities are provided for multi-view editing. An edit operation can be started in one mosaic-view and continued, including its completion, in another mosaic-view. Multi-view editing facilitates the drawing of very long annotation objects, such as bus lines on the integrated circuit, without scrolling mosaic-views. In multi-view editing the image-mosaics need not be associated with the same deconstruction step.

Edit operations performed between mosaic-views may be subject to the following rules:
an annotation object is associated with the annotation overlay displayed in the mosaic-view in which the edit operation started; and
moving or copying an annotation object associates the annotation object with the annotation overlay displayed in the mosaic-view in which the edit operation ended.

At least the mosaic-view associated with the master-cursor may have a toolbar for retrieving common annotation objects. The toolbar may permit an engineer analyst to retrieve simple or complex annotation objects, each annotation object representing one or more components of an integrated circuit. The mosaic-view includes a toolbar.

Annotation objects can be manipulated together by selecting a set of annotation objects and invoking an operator. The toolbar may also include select-and-works click access to operators for performing operations on selected annotation objects. The operators for performing operations on annotation objects may be primitive or complex. Facilities for defining complex operators may also be provided. Using the operators, annotation objects can be deleted, edited, moved, rotated, mirrored, resized, etc. A facility is also preferably provided for undoing and redoing operations. Annotation objects can be hidden to prevent inadvertent editing thereof, but hidden objects may be selected and brought to the foreground. Annotation objects can also be locked to prevent editing. Locked objects may be selected and unlocked to enable editing.

To facilitate manipulation, annotation objects can be grouped into annotation object groups. The annotation objects can be grouped hierarchically, that is an annotation object group may include one or more constituent annotation object group(s). The annotation object groups can be selected and ungrouped at any time. Annotation objects created using polygon primitives are grouped together as an annotation object group. The grouping of annotation objects into annotation object groups enables cell/component specification and extraction. A cell is an annotation object group that has been given a name. Typically, cells are used to represent components or small circuits such as logic gates, flip-flops, etc.

A component cell corresponding to the annotation object group represents a transistor. A cell may be assigned properties by the engineer analyst. Cell properties may include specification of at least one port. Each port is assigned a signal directionality such as: input signaling, output signaling and bidirectional signaling. The DAW also provides facilities for the creation of cell libraries. A cell library is a collection of cells used for the analysis of ICs.

Annotation objects have attributes. Each annotation object includes predefined attributes specifying information related to the annotation object. Selected attributes are editable. The annotation object attributes include: hollow/filled, solid fill/stippled fill, fill color, border color, border width, text label angle, text font, text color, etc. The polygons can be a set of straight lines or Bezier curves, or combinations of the two.

Wires and contacts are special annotation objects having layer attributes used to represent interconnect entities. Wires and contacts also have signal carrying characteristics. Wire annotation objects have an associated layer attribute that specifies the layer of an integrated circuit on which the wire is located. The layer associated with a wire annotation object may be different from the image-mosaic from which the information for creating the wire annotation object was inferred.

Two wire annotation objects respectively specify layer attributes indicating that the annotation object is located on Metal2 layer and annotation object is located on Metal1 layer. A contact annotation represents an electrical contact between two or more components. Contacts between components are preferably represented as circles or crosses. Each contact has two layer attributes. The contact has its associated layer attributes set to Metal1 layer and Metal2 layer.

The wire annotation labeling process is started when a wire annotation object labeling operation is invoked for a wire annotation object. If a selected wire annotation object has a signal property, a wire label is created and the wire annotation object labeling process ends. If it is determined that the wire annotation object does not have a signal property, the design analysis workstation searches attributes of annotation objects and/or cells connected to the selected wire annotation object to determine their respective signal properties. If an unambiguous signal property can be determined, then the signal property is propagated to all connected components and a wire annotation object label is generated. Otherwise, the engineer analyst is prompted for a signal label to be propagated to the connected components. Input from the engineer analyst specifying the signal label is accepted.

Another embodiment of the design analysis workstation in accordance with the invention provides a facility for automatically labeling annotation objects on creation. The labels may be numerical or text labels, for example. In an embodiment of the invention in which an IC is analyzed concurrently by a plurality of engineer analysts using a plurality of design analysis workstations, the facility for automatic labeling provides globally unique labeling suffixes to ensure that labeling conflicts do not arise.

The design analysis workstation also includes a facility for performing measurements. The measurement utilities include facilities for obtaining linear measurements, such as distances between components, trace widths, etc. Area measurements that specify the area covered by a polygonal component may also be obtained.

Annotation objects can also be associated with annotation object properties. Arbitrary information can be added to annotation objects using annotation object properties. An annotation object property is a key-value pair, where the key and the value are arbitrary strings of characters. Each annotation object can have any number of associated annotation object properties.

Annotation objects may also be organized in annotation object groups. Annotation object groups may have attributes and properties. The annotation object group attributes and properties may have an overriding effect on selected attributes and properties of the constituent annotation objects in an annotation object group. An annotation object group has editable attributes that permit the specification of repeating structures, arrayed components and arrayed cells. An example of a repeating structure is a signal bus. Memory cells are an example of arrayed cells. The design analysis workstation also provides a facility for displaying attributes and properties associated with annotation objects and annotation object groups.

Pop-up windows respectively display attribute and property information related to annotation object and annotation object group. The pop-up windows may be displayed by the design analysis workstation in response to an interactive event, such as a mouse-click, a key press, an activation of a menu selection, etc. The pop-up windows may be transient or may be configured to persist, pending an action by the engineer analyst to close the window(s).

The design analysis workstation provides an engineer analyst with a facility for selecting annotation objects based on criteria related to attributes and/or properties associated with an annotation object or an annotation object group. Criteria based selection of annotation objects or object groups is optionally subject to recursive searches. If so, recursive searches parse annotation object constituents of annotation object groups. Recursive searching through constituents of annotation object groups may be suppressed. Criteria based searches can be logically combined and selection criteria for annotation objects can be manipulated using boolean logic.

The design analysis workstation also provides a facility for panning or zooming onto annotation objects selected using criteria-based searches. Labels corresponding to annotation objects selected using a criteria-based search may be displayed in a search result view. The activation of the pan or zoom facility is preferably activated by double clicking on annotation objects listed in a search result view.

The design analysis workstation enables recursive editing of annotation objects and annotation object groups. Recursive editing includes suspending an edit operation to start or perform another operation. For example, a mosaic-view may be panned or zoomed during an edit operation. A benefit derived from recursive editing is the ability to save annotation objects to permanent storage in the middle of an edit operation. Preferably recursive edits may be nested indefinitely, subject to available resources.

An image-mosaic comparison view derived from combined portions of image-mosaics of the oxide layer and polysilicon layer)of a slice may be created The image-mosaic comparison view is derived by selecting two or more mosaic-views of interest. The design analysis workstation derives two "snapshots" from the respective mosaic-views. The snapshots are combined in the image-mosaic comparison.

A no operation (NoOp) combination is a simple combination of selected mosaic-views. An Add combination of two snapshots performs a pixel-by-pixel addition of the pixel intensities of each of the selected mosaic-views. The Add combination is used for overlaying image-mosaics captured at the same location on any integrated circuit during different deconstruction steps. A FirstMinusSecond display of the two snapshots performs a pixel-by-pixel subtraction of the pixel intensities of the second snapshot from the pixel intensities of the first snapshot. The image-mosaic comparison view is a FirstMinusSecond combination of the mosaic-views. The common structure is subtracted from the image comparison mosaic-view. A SecondMinusFirst combination of the two snapshots performs a pixel-by-pixel subtraction of the pixel intensities of the first snapshot from the pixel intensities of the second snapshot. Dissimilar intensity areas show up as light or dark regions. Areas with similar pixel values in both snapshots produce in a dull gray appearance in the image-mosaic comparison view.

In an AbsoluteDifference combination, the pixel intensities are subtracted pixel-by-pixel and then an absolute value is used. The result is a contrast-stretched to cover the full brightness range. This is very useful for inspecting small differences in otherwise similar areas e.g. if areas of similarity are dark, the differences are bright in an AbsoluteDifference combination image-mosaic comparison view.

An Interweave combination useful for combining two portions of image mosaics of the same area, but on different layers. The pixels of the two snapshots are interleaved in a checkerboard pattern. The Interweave combination has a function similar to the Add combination, and improves on brightness and color fidelity at the expense of pixel resolution.

A Flip combination is also provided. The Flip combination is used to display two or more snapshots alternately. The alternating display of the snapshots can be repeated at a selected repetition interval so that the differences stand out as "moving" features.

Integrated circuit design includes mirrored structures. In order to obtain a useful combination of snapshots a mirror function is provided to permit mirrored structures to be overlaid in a mirrored orientation so that differences, if any, are readily observed. The image processing window preferably displays a lock-step cursor, and the motion of the lockset cursor preferably takes mirroring into account.

As mentioned above, a plurality of engineer analysts may collaborate in extracting design and layout information from a chip using the design analysis workstation in accordance with the invention. Facilities are therefore provided to assist in parallel design and layout extraction.

Certain basic features are required in the design analysis workstation to accommodate parallel design and layout extraction. Those features include annotation ownership tracking, unique annotation label generation, annotation locking and annotation merging. These facilities represent only the basic functionality required for collaborative design analysis.

Annotation ownership tracking keeps track of an identification of the engineer analyst who created each annotation and only permits modifications thereof by the creator. Unique annotation label generation ensures that each identifier generated is unique across the project, even if several engineer analysts are working on a project simultaneously. Annotation locking enables a creator of an annotation to "lock" an annotation object thus preventing editing by others of the annotation object to prevent accidental modifications. Annotation merging enables the loading of annotation objects owned by other engineer analysts.

The design analysis workstation also provides a facility for the propagation of signal information between components connected by wire and/or contact annotation objects. Each wire and contact annotation object has a property with a signal key. The signal key represents the name of the signal that the associated wire or contact carries. The signal propagation process may involve a search for all connected sets of wire annotation objects and contact annotation objects associated with a particular integrated circuit. A first of the sets is selected, and annotation objects in that set which have a signal property are located. If the signal specifications of all annotation objects found have the same signal value, the signal value is propagated to all annotation objects in the connected set. The set is discarded and if there are any other sets left to process another set is selected and the process resumes.

If the connected set of annotations objects has two or more different signal values, an attempt is made to propagate the signals until conflicts arise. The conflicts are flagged for display and further investigation by the engineer analyst. Signal conflicts indicate electrical shorts, which normally point to errors in the design analysis.

The design analysis workstation provides a facility for browsing and inspecting signal conflicts. The facility may include a pop-up view with at least one signal conflict location displayed therein. Navigation buttons are preferably provided for browsing and inspecting the conflicts. All signal conflict flags have certain properties attached. Those properties include a property having an "error" key with a "short" value. Properties having a "signal" key and a "signal label" value are created for each conflicting signal. The labels of the annotation objects specifying the conflicting signals may also be specified by an engineer analyst using the design analysis workstation. Propagation of signals may be prevented by locked annotation objects created by a different engineer analyst. In such cases signal conflicts are preferably flagged, but the signal values are not propagated.

The design analysis workstation also provides a facility for extracting design information from interconnected annotation objects. The extraction of design information is used to generate a net-list of components and connections. Net-lists are well known in the art.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises," "comprising," "includes," and/or "including" used in this specification specify the presence of stated features, integers, steps, operations, elements, and/or components, but do not preclude the presence or addition of one or more other features, integers, steps, operations, elements, components, and/or groups thereof.

The corresponding structures, materials, acts, and equivalents of all means or step plus function elements in the claims below are intended to include any structure, material, or act for performing the function in combination with other claimed elements as specifically claimed. The description of the various embodiments has been presented for purposes of illustration and description, but is not intended to be exhaustive or to limit the invention to the forms disclosed. Many modifications and variations will be apparent to those of ordinary skill in the art without departing from the scope and gist of the invention. The various embodiments included herein were chosen and described in order to best explain the principles of the invention and the practical application, and to enable others of ordinary skill in the art to understand the invention for various embodiments with various modifications as are suited to the particular use contemplated.

## Claims

1. A method for examining a complimentary metal-oxide-semiconductor (CMOS) integrated circuit (IC), the method comprising:
removing (102) at least some material of the CMOS IC above a contact etch stop layer (CESL);
etching (103) the CMOS IC for a length of time to remove at least some of the CESL;
inspecting the CMOS IC to differentiate areas of CESL; and
determining, (105) based on the differentiated areas of CESL, a first area of the CMOS IC that comprises a p-channel metal-oxide-semiconductor device (p-FET) and a second area of the CMOS IC that comprises an n-channel metal-oxide-semiconductor device (n-FET).

2. The method of claim 1, further comprising:
creating a cross section of a device that was fabricated using a process that is the same as used for the CMOS IC; and
examining the cross section to determine different CESL characteristics of p-FETs than n- FETs of the cross-sectioned device.

3. The method of claim 2, further comprising:
measuring a thickness of the CESL; and
determining the length of time to etch the CMOS IC based on the thickness of the CESL.

4. The method of claim 1, wherein the removal of the at least some material comprises at least one process selected from a group consisting of wet etching, dry etching, chemical mechanical polishing (CMP), chemical polishing and mechanical polishing.

5. The method of claim 1, wherein the length of time is a predetermined period of time, for example between 30 and 60 seconds.

6. The method of claim 1, further comprising:
deciding that not enough of the CESL has been etched away to differentiate areas of CESL covering an n-FET from areas of CESL covering a p-FET; and
re-etching the CMOS IC using for another period of time to remove at least some more of the CESL.

7. The method of claim 6, wherein the other period of time is less than or equal to the length of time.

8. The method of claim 1, wherein the etching uses a wet etch process, for example which uses a mixture of water, hydrofluoric acid and acetic acid.

9. The method of claim 1, wherein the inspecting of the CMOS IC utilizes scanning electron microscopy.

10. The method of claim 1, wherein the determining the first area and the second area comprises:
finding a first device footprint associated with CESL having a first characteristic;
finding a second device footprint associated with CESL having a second characteristic; and
determining the first device footprint to be the first area and the second device footprint to be the second area.

11. The method of claim 10, wherein the first characteristic is a first amount of CESL remaining and the second characteristic is a second amount of CESL remaining, wherein the second amount of CESL is less than the first amount of CESL, for example no CESL.

12. The method of claim 1, wherein the determining the first area and the second area comprises:
finding a first device footprint having at least some CESL remaining;
finding a second device footprint having no CESL remaining; and
determining the first device footprint to be the first area and the second device footprint to be the second area.

13. The method of claim 1, wherein the determining the first area and the second area comprises:
finding a first device footprint having little to no CESL remaining;
finding a second device footprint with more CESL remaining than the first device footprint; and
determining the first device footprint to be the first area and the second device footprint to be the second area.

14. The method of claim 1, wherein the CMOS IC comprises an n-FET and a p-FET, both built on top of a layer of a non-conductive material.

15. The method of claim 14, wherein the layer of non-conductive material is on top of a substrate of silicon.

## Patentansprüche

1. Verfahren zum Überprüfen einer integrierten komplementären Metalloxid-Halbleiter(complimentary metal-oxide-semiconductor, CMOS)-Schaltung (integrated circuit, IC), das Verfahren umfassend:
Entfernen (102)
von mindestens einigem Material der CMOS-IC über einer Kontaktätzstoppschicht (contact etch stop layer, CESL);
Ätzen (103)
der CMOS-IC für eine Zeitdauer, um wenigstens einiges der CESL zu entfernen;
Prüfen der CMOS-IC, um Bereiche der CESL zu differenzieren; und
Bestimmen, (105), basierend auf den differenzierten Bereichen der CESL, eines ersten Bereichs der CMOS-IC, der eine p-Kanal-Metalloxid-Halbleiter-Vorrichtung (p-FET) umfasst, und eines zweiten Bereichs der CMOS-IC, der eine n-Kanal-Metalloxid-Halbleiter-Vorrichtung (n-FET) umfasst.

2. Verfahren gemäß Anspruch 1, ferner umfassend: Erzeugen eines Querschnitts einer Vorrichtung, die unter Verwendung eines Prozesses hergestellt wurde, welcher der gleiche wie der für die CMOS-IC verwendete ist; und Überprüfen des Querschnitts, um unterschiedliche CESL-Merkmale der p-FETs gegenüber n-FETs der im Querschnitt präsentierten Vorrichtung zu bestimmen.

3. Verfahren gemäß Anspruch 2, ferner umfassend: Messen einer Dicke der CESL; und Bestimmen der Zeitdauer, um die CMOS-IC basierend auf der Dicke der CESL zu ätzen.

4. Verfahren gemäß Anspruch 1, wobei die Entfernung des mindestens einigem Materials mindestens einen Prozess ausgewählt aus einer Gruppe bestehend aus Nassätzen, Trockenätzen, chemisch-mechanisches Polieren (CMP), chemisches Polieren und mechanisches Polieren umfasst.

5. Verfahren gemäß Anspruch 1, wobei die Zeitdauer eine vorbestimmte Zeitdauer ist, zum Beispiel zwischen 30 und 60 Sekunden.

6. Verfahren gemäß Anspruch 1, ferner umfassend: Entscheiden, dass nicht genug der CESL weggeätzt wurde, um Bereiche der CESL, die eine n-FET bedeckt, von Bereichen der CESL, die eine p-FET bedeckt, zu differenzieren; und Erneutes Ätzen der CMOS-IC unter Verwendung einer anderen Zeitdauer, um wenigstens einiges der CESL zu entfernen.

7. Verfahren gemäß Anspruch 6, wobei die andere Zeitdauer weniger als die oder gleich der Zeitdauer ist.

8. Verfahren gemäß Anspruch 1, wobei das Ätzen einen Nassätzprozess verwendet, der zum Beispiel eine Mischung aus Wasser, Flusssäure und Essigsäure verwendet.

9. Verfahren gemäß Anspruch 1, wobei das Prüfen der CMOS-IC Rasterelektronenmikroskopie (scanning electron microscopy, SEM) verwendet.

10. Verfahren gemäß Anspruch 1, wobei das Bestimmen des ersten Bereichs und des zweiten Bereichs umfasst:
Finden eines mit CESL assoziierten ersten Vorrichtungsfußabdrucks mit einem ersten Merkmal;
Finden eines mit CESL assoziierten zweiten Vorrichtungsfußabdrucks mit einem zweiten Merkmal; und
Bestimmen, dass der erste Vorrichtungsfußabdruck der erste Bereich ist und der zweite Vorrichtungsfußabdruck der zweite Bereich ist.

11. Verfahren gemäß Anspruch 10, wobei das erste Merkmal eine erste Menge von zurückbleibender CESL ist, und das zweite Merkmal eine zweite Menge von zurückbleibender CESL ist, wobei die zweite Menge von CESL weniger als die erste Menge von CESL ist, zum Beispiel keine CESL.

12. Verfahren gemäß Anspruch 1, wobei das Bestimmen des ersten Bereichs und des zweiten Bereichs umfasst:
Finden eines ersten Vorrichtungsfußabdrucks mit mindestens einiger zurückbleibender CESL;
Finden eines zweiten Vorrichtungsfußabdrucks mit keiner zurückbleibenden CESL; und Bestimmen, dass der erste Vorrichtungsfußabdruck der erste Bereich ist und der zweite Vorrichtungsfußabdruck der zweite Bereich ist.

13. Verfahren gemäß Anspruch 1, wobei das Bestimmen des ersten Bereichs und des zweiten Bereichs umfasst:
Finden eines ersten Vorrichtungsfußabdrucks mit wenig oder keiner zurückbleibenden CESL; Finden eines zweiten Vorrichtungsfußabdrucks mit mehr zurückbleibender CESL als der erste Vorrichtungsfußabdruck; und
Bestimmen, dass der erste Vorrichtungsfußabdruck der erste Bereich ist und der zweite Vorrichtungsfußabdruck der zweite Bereich ist.

14. Verfahren gemäß Anspruch 1, wobei die CMOS-IC eine n-FET und eine p-FET umfasst, beide auf der Oberseite einer Schicht aus einem nicht leitenden Material gebaut.

15. Verfahren gemäß Anspruch 14, wobei die Schicht aus nicht leitendem Material auf der Oberseite eines Substrats aus Silizium liegt.

## Revendications

1. Méthode d'examen d'un circuit intégré à semi-conducteur à oxyde de métal complémentaire (CMOS), la méthode comprenant :
l'enlèvement (102)
d'au moins une partie du matériau du circuit intégré CMOS au-dessus d'une couche d'arrêt de gravure de contact (CESL) ;
la gravure (103)
du circuit intégré CMOS pendant un certain temps pour enlever au moins une partie de la CESL ;
l'inspection du circuit intégré CMOS pour différencier des zones de la CESL ; et
la détermination (105), sur la base de zones différenciées de la CESL, d'une première zone du circuit intégré CMOS comprenant un dispositif à semi-conducteur à oxyde de métal à canal p (p-FET), et une deuxième zone du circuit intégré CMOS comprenant un dispositif à semi-conducteur à oxyde de métal à canal n (n-FET).

2. Méthode selon la revendication 1, comprenant en outre :
la création d'une section transversale d'un dispositif fabriqué à l'aide d'un procédé identique à celui qui est utilisé pour le circuit intégré CMOS ; et
l'examen de la section transversale pour déterminer différentes caractéristiques des p-FET et n-FET du dispositif à section transversale.

3. Méthode selon la revendication 2, comprenant en outre :
la mesure d'une épaisseur de la CESL ; et
la détermination de la durée de la gravure du circuit intégré CMOS en fonction de l'épaisseur de la CESL.

4. Méthode selon la revendication 1, l'élimination d'au moins une partie du matériau comportant au moins un procédé sélectionné parmi les procédés d'un groupe comprenant : la gravure humide, la gravure à sec, le polissage chimico-mécanique (CMP), le polissage chimique, et le polissage mécanique.

5. Méthode selon la revendication 1, la durée étant une période prédéterminée, comprise, par exemple, entre 30 et 60 secondes.

6. Méthode selon la revendication 1, comprenant en outre :
décider que l'on n'a pas éliminé par attaque une CESL suffisante pour différencier des zones de la CESL couvrant un n-FET de zones de la CESL couvrant un p-FET ; et
re-graver le circuit intégré CMOS en utilisant une nouvelle période pour enlever au moins un peu plus de la CESL.

7. Méthode selon la revendication 6, l'autre période étant inférieure ou égale à la durée.

8. Méthode selon la revendication 1, la gravure faisant usage d'un procédé de gravure humide, utilisant, par exemple, un mélange d'eau, d'acide chlorhydrique et d'acide acétique.

9. Méthode selon la revendication 1, l'inspection du circuit intégré CMOS faisant usage de la microscopie électronique à balayage.

10. Méthode selon la revendication 1, la détermination de la première zone et de la deuxième zone comportant :
la détermination de l'empreinte d'un premier dispositif associé à la CESL, présentant une première caractéristique ;
la détermination de l'empreinte d'un deuxième dispositif associé à la CESL, présentant une deuxième caractéristique ; et
la détermination de l'empreinte du premier dispositif étant la première zone, et la détermination de l'empreinte du deuxième dispositif étant la deuxième zone.

11. Méthode selon la revendication 10, la première caractéristique étant une première quantité de CESL restante, et la deuxième caractéristique étant une deuxième quantité de CESL restante, la deuxième quantité de CESL étant inférieure à la première quantité de CES, par exemple pas de CESL.

12. Méthode selon la revendication 1, la détermination de la première zone et de la deuxième zone comportant :
la détermination de l'empreinte d'un premier dispositif ayant au moins une partie de la CESL restante ;
la détermination de l'empreinte d'un deuxième dispositif n'ayant pas de CESL restante ; et
la détermination de la première empreinte du dispositif étant la première zone, et la deuxième empreinte du dispositif comme la deuxième zone.

13. Méthode selon la revendication 1, la détermination de la première zone et de la deuxième zone comportant :
la détermination de l'empreinte d'un premier dispositif ayant peu, ou aucune, CESL restante ;
la détermination de l'empreinte d'un deuxième dispositif avec plus de CESL restante que l'empreinte du premier dispositif ; et
la détermination de l'empreinte du premier dispositif comme étant la première zone, et l'empreinte du deuxième dispositif comme étant la deuxième zone.

14. Méthode selon la revendication 1, le circuit intégré CMOS comprenant un n-FET et un p-FET, tous les deux construits sur le dessus d'une couche d'un matériau non conducteur.

15. Méthode selon la revendication 14, la couche de matériau non conducteur se trouvant sur le dessus d'un substrat de silicium.
